# EUROPÄISCHE PATENTANMELDUNG

(11) **EP 4 403 932 A1**
(43) Veröffentlichungstag der Anmeldung: **24.07.2024**
(21) Anmeldenummer: 24150550.2
(22) Anmeldetag: 05.01.2024
(51) Int. Cl.: G01R 19/25, G01R 31/08

(54) **VERFAHREN UND VORRICHTUNG ZUR KABELFEHLERFRÜHERKENNUNG**

(30) Priorität: 20.01.2023 DE 102023101474
(71) Anmelder: Westnetz GmbH, 44139 Dortmund (DE)
(72) Erfinder: Deutsch, Johannes, 54295 Trier (DE); Lombard, Ralf, 54516 Wittlich (DE)
(74) Vertreter: Bals & Vogel Patentanwälte PartGmbB

(57) **Zusammenfassung**

Die Erfindung betrifft ein Verfahren (100) zur Überwachung wenigstens einer Energieleitung (5) in einem Mittelspannungsnetz (3), die Energieleitung (5) wenigstens umfassend einen Innenleiter (5.3) sowie wenigstens einen Kabelschirm (5.5), wobei der Innenleiter (5.3) zumindest abschnittsweise von dem Kabelschirm (5.5) ummantelt ist und wobei an dem Innenleiter (5.3) zumindest temporär eine, vorzugsweise sinusförmige, elektrische Wechselspannung mit einer ersten Frequenz anliegt.

## Beschreibung

Die Erfindung betrifft ein Verfahren mit den Merkmalen des unabhängigen Patentanspruchs 1, eine Vorrichtung mit den Merkmalen des unabhängigen Patentanspruchs 10, ein Umspannwerk mit den Merkmalen des unabhängigen Patentanspruchs 12, ein System mit den Merkmalen des unabhängigen Patentanspruchs 13, ein Computerprogrammprodukt mit den Merkmalen des unabhängigen Patentanspruchs 14 sowie ein computerlesbares Speichermedium mit den Merkmalen des unabhängigen Patentanspruchs 15.

Die Verteilung des elektrischen Stroms zur Energieversorgung von Haushalten und Industriebetrieben erfolgt auf Grundlage mehrerer Stromnetz- bzw. Spannungsebenen. Eine überregionale Verteilung des Stroms erfolgt über Hochspannungsnetze. Eine daran anschließende regionale Unterverteilung wird hingegen über Mittelspannungsnetze realisiert. Die Belieferung der Endkunden erfolgt schließlich über lokale Verteilnetze, welche mit Niederspannung betrieben werden. Den einzelnen Netz- bzw. Spannungsebenen sind Transformationsanlagen (bspw. Umspannwerke oder Transformatorenstationen) zwischengeschaltet, welche bspw. eine Transformation von Hochspannung auf Mittelspannung oder von Mittelspannung auf Niederspannung ermöglichen.

Da das Mittelspannungsnetz unmittelbar zur regionalen Verteilung elektrischer Energie dient, führen Fehler und Störungen in Energieleitungen von Mittelspannungsnetzen häufig zu einer regional ausgedehnten Beeinträchtigung von Endkunden. Eine solche Beeinträchtigung kann bspw. der zumindest temporäre Wegfall der Energieversorgung einzelner Haushalte und/oder Betriebe sein, da im Falle einer gestörten Energieleitung eines Mittelspannungsnetzes eine reibungslose Energieversorgung der eines an das Mittelspannungsnetz anknüpfenden Niederspannungsnetzes mitunter nicht sichergestellt werden kann. Entsprechend sind auch Fehler und Störungen, welche lediglich eine kurze Unterbrechung der Energieversorgung auf einzelnen Energieleitungen des Mittelspannungsnetzes bewirken, oft unmittelbar durch eine Vielzahl von Endkunden wahrnehmbar.

Der Wegfall der Energieversorgung einzelner Haushalte und/oder Betriebe wirkt sich unmittelbar auf die Zufriedenheit der Endkunden aus und kann je nach Dauer immense Schäden verursachen. So kann es im Falle einer unterbrochenen Energieversorgung dazu kommen, dass die Produktions- bzw. Geschäftsaktivitäten in den betroffenen Betrieben lediglich eingeschränkt oder gar nicht aufrechterhalten werden können. Ferner können Sicherheitssysteme in ihrer Funktion beeinträchtigt werden. Auch der Betrieb von Kühlgeräten, bspw. zur Lagerung von Lebensmitteln, kann im Falle einer fehlenden Energieversorgung nicht aufrechterhalten werden. Der Wegfall der Energieversorgung bei Endkunden zieht ferner Vertragsstrafen nach sich, welche durch den Energieversorger zu entrichten sind. Aufgrund der regional ausgedehnten Ausfälle bei einer Beeinträchtigung des Mittelspannungsnetzes ergeben sich im Schadensfall entsprechend hohe Zahlungen, welche es bestmöglich zu vermeiden gilt.

Es ist daher eine Aufgabe der vorliegenden Erfindung, wenigstens einen der voranstehend beschriebenen Nachteile zumindest teilweise zu überwinden. Insbesondere ist es Aufgabe der Erfindung einen möglichst stabilen und zuverlässigen Betrieb eines Mittelspannungsnetzes auf möglichst einfache und/oder kostengünstige Weise sicherzustellen.

Die voranstehende Aufgabe wird gelöst durch ein Verfahren mit den Merkmalen des unabhängigen Patentanspruchs 1, durch eine Vorrichtung mit den Merkmalen des unabhängigen Patentanspruchs 10, durch ein Umspannwerk mit den Merkmalen des unabhängigen Patentanspruchs 12, durch ein System mit den Merkmalen des unabhängigen Patentanspruchs 13, durch ein Computerprogrammprodukt mit den Merkmalen des unabhängigen Patentanspruchs 14 sowie durch ein computerlesbares Speichermedium mit den Merkmalen des unabhängigen Patentanspruchs 15. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit der erfindungsgemäßen Vorrichtung und/oder im Zusammenhang mit dem erfindungsgemäßen Umspannwerk und/oder im Zusammenhang mit dem erfindungsgemäßen System und/oder im Zusammenhang mit dem erfindungsgemäßen Computerprogrammprodukt und/oder im Zusammenhang mit dem erfindungsgemäßen computerlesbaren Speichermedium und jeweils umgekehrt, so dass bezüglich der Offenbarung zu den einzelnen Erfindungsaspekten stets wechselseitig Bezug genommen wird bzw. werden kann.

Erfindungsgemäß vorgesehen ist ein Verfahren zur Überwachung wenigstens einer Energieleitung in einem Mittelspannungsnetz, die Energieleitung wenigstens umfassend einen Innenleiter sowie wenigstens einen Kabelschirm, wobei der Innenleiter zumindest abschnittsweise von dem Kabelschirm ummantelt ist und wobei an dem Innenleiter zumindest temporär eine, vorzugsweise sinusförmige, elektrische Wechselspannung mit einer ersten Frequenz anliegt, das Verfahren wenigstens umfassend:
- Erfassen von Spannungswerten durch eine zeitdiskrete Erfassung der elektrischen Spannung auf dem Kabelschirm der Energieleitung, insbesondere durch eine Erfassungseinheit, wobei die Erfassung der Spannungswerte mit einer zweiten Frequenz erfolgt, wobei die zweite Frequenz zur Erfassung der Spannungswerte höher ist als die erste Frequenz der Wechselspannung und wobei das Erfassen der Spannungswerte für hochfrequente Spannungsanteile in einem Frequenzband erfolgt, wobei das Frequenzband durch eine untere Grenze und eine obere Grenze begrenzt ist, wobei die untere Grenze wenigstens 1 kHz beträgt und die obere Grenze höchstens 100 kHz beträgt,
- Auswerten wenigstens eines Spannungswerts, insbesondere durch eine Auswerteeinheit, das Auswerten umfassend einen Vergleich der des Spannungswerts mit einem Spannungsgrenzwert,
- Aktivieren eines Alarmprotokolls, insbesondere durch eine Steuereinheit, sofern der Spannungsgrenzwert durch wenigstens einen der erfassten Spannungswerte überschritten wurde.

In anderen Worten wird durch die Erfindung ein Verfahren zur Überwachung wenigstens einer Energieleitung eines Niederspannungsnetzes bereitgestellt. An der Energieleitung liegt eine elektrische Wechselspannung mit einer ersten Frequenz an. Ferner umfasst die Energieleitung wenigstens einen, insbesondere genau einen, Kabelschirm sowie wenigstens einen, insbesondere genau einen, Innenleiter, wobei der Innenleiter zumindest abschnittsweise vom Kabelschirm ummantelt ist. Erfindungsgemäß ist vorgesehen, dass eine zeitlich diskrete Erfassung der elektrischen Spannung auf dem Kabelschirm der Energieleitung erfasst wird, wobei die Erfassung der Spannungswerte mit einer zweiten Frequenz erfolgt, die höher ist als die erste Frequenz der Wechselspannung. In anderen Worten ist vorgesehen, dass innerhalb einer Periode bzw. Periodendauer der Wechselspannung mehrere Spannungswerte erfasst werden. Die Erfassung wird dabei für hochfrequente Spannungsanteile in einem Frequenzband von 1 kHz bis 100 kHz durchgeführt. Ferner ist vorgesehen, dass die erfassten Spannungswerte ausgewertet werden, wobei das Auswerten wenigstens einen Vergleich wenigstens eines Spannungswertes mit einem Spannungsgrenzwert umfasst. Die Überschreitung des Spannungsgrenzwerts durch wenigstens einen Spannungswert kennzeichnet dabei ein Fehlereignis in der Energieleitung, sodass in einem solchen Falle ein Alarmprotokoll aktiviert wird, um weitere Aktionen bzw. Sicherheitsmaßnahmen (sofern erforderlich) in die Wege zu leiten.

Im Rahmen der vorliegenden Erfindung wurde festgestellt, dass sich gravierende Fehler in Energieleitungen eines Mittelspannungsnetzes (Kabelfehler), welche bspw. zu Teilausfälle eines Mittelspannungsnetzes zur Folge haben können, zumindest in machen Fehlerfällen durch zeitlich vorhergehende und weniger gravierende Fehlerereignisse ankündigen. Insbesondere wurde festgestellt, dass sich solche weniger gravierenden Fehlerereignisse in Energieleitungen eines Mittelspannungsnetzes als, vorzugsweise wiederkehrende, Teilentladungen in der betreffenden Energieleitung zeigen. Es wurde ferner festgestellt, dass sich diese Teilentladungen in hochfrequenten elektrischen Spannungen in der Energieleitung zeigen. Diese hochfrequenten elektrischen Spannungen sind auf dem Innenleiter der Energieleitung erfassbar. Hierbei gilt es, die an dem Innenleiter anliegenden hohen elektrischen Spannungen zu berücksichtigen. Es hat sich ferner im Rahmen der Erfindung gezeigt, dass die aus Teilentladungen resultierenden hochfrequenten elektrischen Spannungen auf einem weitaus geringeren Spannungsniveau auch auf dem Kabelschirm einer Energieleitung eines Mittelspannungsnetzes erfassbar sind.

Diese Erkenntnis wurde im Rahmen der vorliegenden Erfindung gewinnbringend genutzt. Durch das erfindungsgemäße Verfahren wird die elektrische Spannung auf dem Kabelschirm einer Energieleitung zeitdiskret erfasst. Hierdurch ergibt sich der Vorteil einer im Vergleich zu einer Erfassung auf dem Innenleiter vereinfachten messtechnischen Erfassung der Teilentladungen. Dabei werden die Spannungswerte in einer zweiten Frequenz erfasst, wobei die zweite Frequenz höher ist als die erste Frequenz der an der Energieleitung anliegenden Wechselspannung. Hierdurch ergibt sich der Vorteil, dass auch kurzzeitig (bspw. in einer Halbschwingung der Wechselspannung) auftretende Fehlerereignisse zuverlässig erfasst werden können. Auch hat sich herausgestellt, dass die durch eine Teilentladung erzeugten hochfrequenten elektrischen Spannungen sich über ein breites Frequenzband erstrecken. Es hat sich im Zuge der Erfindung als besonders vorteilhaft erwiesen, zur Detektion einer Teilentladung lediglich Spannungsanteile in einem definierten Frequenzband zwischen 1 kHz und 100 kHz zu erfassen. Hierdurch wird der Vorteil erzielt, dass eine Beeinflussung des erfassten Signals durch Fremdeinflüsse (wie bspw. Funksignale) vermieden bzw. reduziert werden kann und Teilentladungen somit zuverlässig detektiert werden können. Entsprechend ergibt sich in Bezug auf die vorliegende Erfindung der Vorteil, dass bereits weniger gravierende Fehler in einer Energieleitung eines Mittelspannungsnetzes zuverlässig detektiert und entsprechende Sicherheits- bzw. Wartungsmaßnahmen in die Wege geleitet werden können. Hierdurch kann größeren Schäden an der betreffenden Energieleitung sowie einer regional ausgedehnten Unterbrechung der Energieversorgung vorgebeugt werden. Entsprechend kann durch das erfindungsgemäße Verfahren der zuverlässige und stabile Betrieb eines Mittelspannungsnetzes auf einfache Weise sichergestellt werden.

Eine Energieleitung soll vorliegend als eine Leitung verstanden werden, über welche elektrische Energie bzw. Strom geleitet wird. Beispielsweise kann es sich hierbei um eine Energieleitung innerhalb eines Mittelspannungsnetzes handeln. Eine Energieleitung eines Mittelspannungsnetzes umfasst wenigstens einen Innenleiter sowie wenigstens einen Kabelschirm, wobei der Innenleiter zumindest abschnittsweise von dem Kabelschirm ummantelt ist. Zwischen dem Innenleiter und dem Kabelschirm können weitere Materialien, wie bspw. ein Isolationsmaterial, angeordnet sein. Ferner kann es vorgesehen sein, dass das Energiekabel zum Schutz vor äußeren Einflüssen mit einer Außenisolierung ummantelt ist.

Der Kabelschirm dient zur elektromagnetischen Abschirmung des Innenleiters des Energiekabels. Es kann vorgesehen sein, dass der Kabelschirm zumindest abschnittsweise aus einem Metall und/oder einem Drahtgeflecht ausgebildet ist. Das Drahtgeflecht kann dabei eine Vielzahl von Schirmdrähten umfassen. Zusätzlich oder alternativ kann es vorgesehen sein, dass der Innenleiter eine Vielzahl von, insbesondere geflochtenen, Leitungsdrähten, umfasst. Insbesondere kann das Energiekabel derart ausgebildet sein, dass der Kabelschirm nach einem zumindest abschnittsweisen Auftrennen einer Außenisolierung des Energiekabels aus dem Kabel herausgeführt werden kann. Hierzu kann es vorgesehen sein, dass der Kabelschirm, insbesondere die Schirmdrähte des Kabelschirms, zu einem Leiter geformt (bspw. gezwirbelt oder geflochten) werden. Hierdurch wird der Kabelschirm für eine messtechnische Erfassung elektrischer Spannungen zugänglich.

Ein Mittelspannungsnetz soll vorliegend als ein Stromnetz verstanden werden, über welches elektrische Energie bzw. Strom, insbesondere regional, verteilt wird, wobei das Niederspannungsnetz mit einer elektrischen Spannung, insbesondere Wechselspannung zwischen 1 kV und 52 kV, insbesondere 10 kV, 20 kV oder 30 kV, betrieben wird. Hiermit ist gemeint, dass an wenigstens einer Energieleitung, insbesondere allen Energieleitungen, des Niederspannungsnetzes im Normalbetrieb eine Spannung zwischen 1 kV und 52 kV, insbesondere eine elektrische Spannung von 10 kV, 20 kV oder 30 kV, anliegt. Niederspannungsnetze weisen im Vergleich hierzu niedrigere elektrische Spannungen auf. Hochspannungsnetze weisen im Vergleich hierzu höhere elektrische Spannungen auf. Insbesondere kann es vorgesehen sein, dass über das Niederspannungsnetz eine regionale Unterverteilung von elektrischer Energie erfolgt. Dabei umfasst das Mittelspannungsnetz wenigstens eine Energieleitung, insbesondere mehrere bzw. eine Vielzahl von Energieleitungen.

Das Mittelspannungsnetz kann Teil eines übergeordneten Stromnetzes mit weiteren Spannungsebenen (Niederspannung, Hochspannung) sein, wobei das übergeordnete Stromnetz mehrere Mittelspannungsnetze umfassen kann, welche bspw. zur elektrischen Versorgung räumlich getrennter Bereiche dienen. Hierunter kann bspw. die elektrische Versorgung verschiedener Regionen durch unterschiedliche Mittelspannungsnetze verstanden werden. Den unterschiedlichen Spannungsebenen des Stromnetzes (Hochspannung, Mittelspannung, Niederspannung) kann jeweils wenigstens eine Transformatorenstation und/oder wenigstens ein Umspannwerk zwischengeschaltet sein.

Eine Transformatorenstation kann bspw. zur Transformation von Hoch- auf Mittelspannung oder von Mittel- auf Niederspannung dienen.

Eine elektrische Wechselspannung ist eine elektrische Spannung, deren Polarität sich regelmäßig umkehrt und deren zeitlicher Mittelwert null ist. Dabei kann der zeitliche Verlauf der Wechselspannung einem Sinusverlauf entsprechen, wobei in diesem Falle eine sinusförmige Wechselspannung vorliegt. Der zeitliche Verlauf der Wechselspannung ist periodisch und weist somit eine Periodendauer auf. Die Frequenz der Wechselspannung ergibt sich als Kehrwert der Periodendauer der Wechselspannung. Insbesondere kann es vorgesehen sein, dass die Periodendauer der Wechselspannung 0,02 s (Sekunden) bzw. die Frequenz der Wechselspannung 50 Hz beträgt.

Die Frequenz einer Erfassung soll vorliegend als eine Abtastrate eines (bspw. durch eine Erfassungseinheit empfangenen) Messignals verstanden werden. Eine Erfassungsfrequenz bzw. Abtastrate von 800 Hz entspräche folglich einer Erfassung von 800 Messwerten (bspw. Spannungswerten) pro Sekunde.

Eine Halbschwingung soll vorliegend als derjenige Anteil einer, insbesondere sinusförmigen, Schwingung verstanden werden, in dem kein Vorzeichenwechsel stattfindet. Entsprechend ist jede Halbschwingung begrenzt durch zwei Nulldurchgänge des betreffenden Signals, bspw. einer Wechselspannung.

Es kann im Rahmen der Erfindung vorgesehen sein, dass einzelne Schritte eines erfindungsgemäßen Verfahrens zumindest teilweise parallel bzw. simultan ausgeführt werden. So kann es bspw. vorgesehen sein, dass das Erfassen von Spannungswerten, insbesondere kontinuierlich, über einen längeren bzw. unbestimmten Zeitraum erfolgt und die erfasste Spannungswerte parallel zur weitergehenden Erfassung, insbesondere kontinuierlich, ausgewertet werden. Auch kann es vorgesehen sein, dass das Erfassen von Spannungswerten bzw. das Auswerten der erfassten Werte nicht durch das Aktivieren eines Alarmprotokolls unterbrochen wird, sondern unabhängig von einzelnen Auswerteergebnissen bzw. der Aktivierung eines Alarmprotokolls weitergeführt wird.

Es kann im Rahmen der Erfindung ferner von Vorteil sein, wenn die Auswertung von Spannungswerten mit der gleichen Frequenz erfolgt wie die Erfassung der Spannungswerte. Hierdurch wird der Vorteil erzielt, dass es keinen Datenstau von erfassten Messwerten gibt, deren Auswertung noch aussteht. Vielmehr kann ein synchroner Ablauf zwischen dem Erfassen und Auswerten von Spannungswerten realisiert werden. Zusätzlich oder alternativ ist es im Rahmen der Erfindung denkbar, dass die Spannungswerte in äquidistanten Zeitabständen erfasst werden.

Es ist im Rahmen der Erfindung denkbar, dass die untere Grenze des Frequenzbandes, in dem hochfrequente Spannungsanteile erfasst werden, wenigstens 10 kHz, insbesondere wenigstens 15 kHz, vorzugsweise wenigstens 20 kHz, beträgt. Alternativ oder zusätzlich kann es vorgesehen sein, dass die obere Grenze des Frequenzbandes, in dem hochfrequente Spannungsanteile erfasst werden, höchstens 80 kHz, insbesondere höchstens 60 kHz, vorzugsweise höchstens 40 kHz, beträgt.

Im Rahmen der Erfindung kann es von Vorteil sein, dass die zweite Frequenz zur Erfassung der Spannungswerte wenigstens das Zweifache der oberen Grenze des Frequenzbandes beträgt. Hierdurch ergibt sich der Vorteil, dass die erfassten hochfrequenten Spannungsanteile bzw. der daraus resultierende Verlauf der elektrischen Spannung möglichst genau exakt rekonstruiert werden kann. Somit können Teilentladungen zuverlässiger detektiert werden.

Im Rahmen der Erfindung ist es denkbar, dass zusätzlich umfasst ist:
- Ermittlung des Spannungsgrenzwerts durch Ermittlung eines zeitlichen Mittelwerts eines Grundrauschens der elektrischen Spannung auf dem Kabelschirm, insbesondere im fehlerfreien Betrieb der Energieleitung, wobei der Spannungsgrenzwert ein Vielfaches, insbesondere wenigstens das 1,5-fache oder wenigstens das Zweifache, des zeitlichen Mittelwerts des Grundrauschens beträgt.

In anderen Worten kann es vorgesehen sein, dass die hochfrequenten Spannungsanteile auf dem Kabelschirm in einem Zeitraum ausgewertet werden, von dem bekannt ist, dass keine Fehlfunktion der Energieleitung vorlag. Die zeitliche Schwankung der elektrischen Spannung auf dem Kabelschirm im fehlerfreien Betrieb der Energieleitung wird als Grundrauschen bezeichnet. Eine zeitliche Mittelung dieses Grundrauschens liefert einen entsprechenden zeitlichen Mittelwert. Der Spannungsgrenzwert kann in Abhängigkeit des ermittelten zeitlichen Mittelwerts des Grundrauschens definiert werden, wobei der Spannungsgrenzwert wenigstens das 1,5-fache oder wenigstens das Zweifache, insbesondere wenigstens das Dreifache oder wenigstens das Vierfache des Grundrauschens beträgt. Durch eine Anpassung des Spannungsgrenzwertes kann die Auslöseschwelle zur Aktivierung eines Alarmprotokolls verschoben werden.

Es kann im Rahmen der Erfindung vorgesehen sein, dass zusätzlich wenigstens eines der folgenden umfasst ist:
- Erstellen wenigstens eines Erfassungsdatensatzes, insbesondere durch eine Speichereinheit oder eine Auswerteeinheit, der Erfassungsdatensatz umfassend wenigstens einen Spannungswert sowie wenigstens einen Zeitstempel, wobei jedem Spannungswert in dem Erfassungsdatensatz ein Zeitstempel zugeordnet ist.
- Speichern wenigstens eines Erfassungsdatensatzes, insbesondere durch eine Speichereinheit bzw. auf einem Datenspeicher, wobei insbesondere jedem Erfassungsdatensatz ein übergeordneter Zeitstempel zugeordnet ist,
- Berechnen, insbesondere durch eine Auswerteeinheit oder eine Speichereinheit, einer Zeitdifferenz zwischen wenigstens einem in einem Erfassungsdatensatz enthaltenen Zeitstempel und einem Referenzzeitstempel und Löschen des dem Zeitstempel zugeordneten Spannungswertes, sofern die Zeitdifferenz einen Zeitgrenzwert überschreitet
   und/oder
   Berechnen, insbesondere durch eine Auswerteeinheit oder eine Speichereinheit, einer Zeitdifferenz zwischen wenigstens einem übergeordneten Zeitstempel eines Erfassungsdatensatzes und einem Referenzzeitstempel und Löschen des dem übergeordneten Zeitstempel zugeordneten Erfassungsdatensatzes, sofern die Zeitdifferenz einen Zeitgrenzwert überschreitet.

In anderen Worten kann es vorgesehen sein, dass im Rahmen eines erfindungsgemäßen Verfahrens ein Erstellen wenigstens eines Erfassungsdatensatzes erfolgt. Die Erstellung kann bspw. in einer Speichereinheit und/oder Auswerteeinheit und/oder Steuereinheit erfolgen. Wenigstens ein Erfassungsdatensatz umfasst wenigstens einen Spannungswert sowie wenigstens einen Zeitstempel, wobei insbesondere jedem Spannungswert wenigstens ein, insbesondere genau ein, Zeitstempel zugeordnet ist. Dabei kann ein einem Spannungswert zugeordneter Zeitstempel charakteristisch sein für den Zeitpunkt an dem der Spannungswert erfasst wurde.

Wenigstens ein Erfassungsdatensatz kann mehrere Spannungswerte und/oder Zeitstempel umfassen. Insbesondere kann es vorgesehen sein, dass wenigstens ein Erfassungsdatensatz mehrere Spannungswerte umfasst, welche über einen zusammenhängenden Erfassungszeitraum erfasst wurden. Hiermit ist gemeint, dass der Erfassungsdatensatz alle in dem Erfassungszeitraum, insbesondere für eine Energieleitung, erfassten Spannungswerte und/oder Zeitstempel umfasst. Hierdurch ergibt sich der Vorteil, dass die erfassten Spannungswerte in einer übersichtlichen und leicht zugänglichen Datenstruktur gebündelt werden, um den Zugang zu relevanten Daten nachfolgend möglichst einfach und effizient zu gestalten. Es kann vorgesehen sein, dass der Erfassungszeitraum den Zeitraum wenigstens einer Stunde, wenigstens eines Tages (24 Stunden) oder wenigstens eines Kalendermonats abbildet.

Ferner kann es vorgesehen sein, dass wenigstens ein Erfassungsdatensatz wenigstens einen, insbesondere genau einen, übergeordneten Zeitstempel umfasst. Der übergeordnete Zeitstempel kann für den durch den Erfassungsdatensatz abgebildeten Erfassungszeitraum charakteristisch sein. Es kann es vorgesehen sein, dass der übergeordnete Zeitstempel wenigstens einen Anfangszeitpunkt des Erfassungszeitraums und/oder wenigstens einen Endzeitpunkt des Erfassungszeitraums umfasst. Hierdurch ergibt sich der Vorteil, dass der Erfassungszeitraum eines Erfassungsdatensatzes einfach und effizient ausgelesen werden kann, ohne dass eine Auswertung der in dem Erfassungsdatensatz enthaltenen Spannungswerte bzw. den jeweils zugeordneten Zeitstempeln erfolgen muss.

Ferner kann es vorgesehen sein, dass im Rahmen der vorliegenden Erfindung ein Speichern wenigstens eines Erfassungsdatensatzes, insbesondere aller Erfassungsdatensätze, erfolgt. Das Speichern kann durch eine Speichereinheit und/oder eine Auswerteeinheit und/oder eine Steuereinheit erfolgen. Ferner kann es vorgesehen sein, dass das Speichern auf wenigstens einem Datenspeicher erfolgt, wobei vorzugsweise wenigstens ein Datenspeicher durch eine Speichereinheit und/oder eine Auswerteeinheit und/oder eine Steuereinheit umfasst ist. Auch ist es denkbar, dass das Speichern wenigstens eines Erfassungsdatensatzes, insbesondere aller Erfassungsdatensätze, redundant erfolgt. Hiermit ist gemeint, dass das Speichern auf zwei unabhängigen Datenspeichern erfolgt. Hierdurch wird der Vorteil erzielt, dass die Erfassungsdatensätze nicht verloren gehen, selbst wenn einer der Datenspeicher funktionell beeinträchtigt ist. Durch die Verwendung weiterer Datenspeicher kann der Grad der Redundanz entsprechend erhöht werden. Wenigstens ein Datenspeicher kann vorzugsweise als ein nichtflüchtiger Datenspeicher, insbesondere als SSD (Solid-State-Drive) oder Flash-Speicher oder ein magnetisches Speichermedium wie ein HDD-Speicher (Hard-Disk-Drive) ausgebildet sein. Das Speichern der erfassten Spannungswerte bietet den Vorteil, dass die erfassten Daten zumindest temporär zugänglich gehalten werden. So können bspw. im Falle einer detektierten Fehlfunktion einer Energieleitung auch zeitlich zurückliegende Messdaten dieser Energieleitung zur Analyse der Fehlfunktion herangezogen werden bzw. sicherheitshalber überprüft werden, ob der Betrieb der Energieleitung in der Vergangenheit tatsächlich fehlerfrei war. Auch kann anhand einer solchen rückschauenden Auswertung der erfassten Spannungswerte eine ggf. erforderliche Anpassung des Spannungsgrenzwerts einfacher abgeleitet werden.

Ferner kann es vorgesehen sein, dass, insbesondere in regelmäßigen Zeitabständen, die Berechnung wenigstens einer Zeitdifferenz zwischen wenigstens einem in einem Erfassungsdatensatz enthaltenen Zeitstempel und einem Referenzzeitstempel, insbesondere durch eine Auswerteeinheit und/oder eine Steuereinheit und/oder eine Speichereinheit, erfolgt. Die Berechnung kann wiederkehrend, insbesondere wenigstens stündlich und/oder wenigstens täglich, durchgeführt werden. Der Referenzzeitstempel kann charakteristisch für einen Referenzzeitpunkt sein, wobei insbesondere anhand des Referenzzeitstempels ein aktuelles Alter eines dem in dem Erfassungsdatensatz enthaltenen Zeitstempel zugeordneten Spannungswerts ermitteln lässt. Es kann vorgesehen sein, dass der Referenzzeitpunkt wiederkehrend, insbesondere in regelmäßigen Zeitabständen, insbesondere mit jeder Initiierung eines Löschvorgangs, aktualisiert wird. Eine Aktualisierung kann bedeuten, dass der Referenzzeitstempel auf die bei der Aktualisierung aktuelle Zeit gesetzt wird. So kann eine Zeitdifferenz aus dem Referenzzeitstempel und dem in dem Erfassungsdatensatz enthaltenen Zeitstempel berechnet und das Alter der dem in dem Erfassungsdatensatz enthaltenen Zeitstempel zugeordneten Spannungswert ermittelt werden. Es kann vorgesehen sein, dass dies für mehrere, insbesondere alle, in wenigstens einem Erfassungsdatensatz enthaltenen Zeitstempel Spannungswerte und/oder für mehrere, insbesondere alle, Erfassungsdatensätze, insbesondere wiederkehrend, durchgeführt wird.

Es kann ferner vorgesehen sein, dass wenn die berechnete Zeitdifferenz einen Zeitgrenzwert überschreitet, ein Löschen des dem in dem Erfassungsdatensatz enthaltenen Zeitstempel zugeordneten Spannungswerts, insbesondere durch eine Auswerteeinheit und/oder eine Steuereinheit und/oder eine Speichereinheit, erfolgt (Löschvorgang). Der Zeitgrenzwert kann wenigstens eine Minute und/oder wenigstens eine Stunde und/oder wenigstens 24 Stunden betragen. Hierdurch ergibt sich der Vorteil, dass Datensätze, in denen keine Fehlfunktion der Energieleitung detektiert wurde bzw. voraussichtlich nicht mehr benötigt werden, regelmäßig gelöscht werden. Hierdurch kann die aufgrund einer hochfrequenten Erfassung der Spannung anfallende Datenmenge reduziert bzw. auf einem konstant niedrigen Niveau gehalten werden. Die Initiierung eines solchen Löschvorgangs kann wenigstens stündlich und/oder wenigstens täglich erfolgen.

Zusätzlich oder alternativ kann es vorgesehen sein, dass, insbesondere in regelmäßigen Zeitabständen, die Berechnung wenigstens einer Zeitdifferenz zwischen wenigstens einem übergeordneten Zeitstempel eines Erfassungsdatensatzes und einem Referenzzeitstempel, insbesondere durch eine Auswerteeinheit und/oder eine Steuereinheit und/oder eine Speichereinheit, erfolgt. Die Berechnung kann wiederkehrend, insbesondere wenigstens stündlich und/oder wenigstens täglich, durchgeführt werden. Der Referenzzeitstempel kann charakteristisch für einen Referenzzeitpunkt sein, wobei insbesondere sich anhand des Referenzzeitstempels ein aktuelles Alter eines Erfassungsdatensatzes ermitteln lässt. Es kann vorgesehen sein, dass der Referenzzeitpunkt wiederkehrend, insbesondere in regelmäßigen Zeitabständen, insbesondere mit jeder Initiierung eines Löschvorgangs. aktualisiert wird. Eine Aktualisierung kann bedeuten, dass der Referenzzeitstempel auf die bei der Aktualisierung aktuelle Zeit gesetzt wird. So kann eine Zeitdifferenz aus dem Referenzzeitstempel und dem übergeordneten Zeitstempel des Erfassungsdatensatzes berechnet und das Alter des Erfassungsdatensatzes ermittelt werden. Es kann vorgesehen sein, dass dies für mehrere, insbesondere alle, Erfassungsdatensätze, insbesondere regelmäßig, durchgeführt wird.

Es kann ferner vorgesehen sein, dass wenn die berechnete Zeitdifferenz einen Zeitgrenzwert überschreitet, ein Löschen des Erfassungsdatensatzes, insbesondere durch eine Auswerteeinheit und/oder eine Steuereinheit und/oder eine Speichereinheit, erfolgt (Löschvorgang). Der Zeitgrenzwert kann wenigstens eine Minute und/oder wenigstens eine Stunde und/oder wenigstens 24 Stunden betragen. Hierdurch ergibt sich der Vorteil, dass Datensätze, in denen keine Fehlfunktion der Energieleitung detektiert wurde bzw. die voraussichtlich nicht mehr benötigt werden, regelmäßig gelöscht werden. Eine gebündelte Betrachtung von Erfassungsdatensätzen anstatt aller in einem Erfassungsdatensatz enthaltenen Spannungswerte ermöglicht ferner eine effizientere Durchführung der Löschvorgänge. Hierdurch kann die aufgrund einer hochfrequenten Erfassung der elektrischen Spannung anfallende Datenmenge reduziert bzw. auf einem konstant niedrigen Niveau gehalten werden. Die Initiierung eines solchen Löschvorgangs kann wenigstens stündlich und/oder wenigstens täglich erfolgen.

Auch ist es denkbar, dass das Alarmprotokoll zusätzlich wenigstens eines der nachfolgenden umfasst:
- Erstellen und/oder Bereitstellen wenigstens eines Fehlerdatensatzes, insbesondere durch eine Steuereinheit, der Fehlerdatensatz umfassend wenigstens einen Spannungswert sowie wenigstens Zeitstempel, wobei jedem Spannungswert in dem Erfassungsdatensatz wenigstens ein, insbesondere genau ein, Zeitstempel zugeordnet ist,
- Übertragen wenigstens eines bzw. des Fehlerdatensatzes, insbesondere durch eine Kommunikationseinheit, an einen zentralen Server und/oder an wenigstens ein mobiles Gerät,
- Empfangen wenigstens einer Betriebsanweisung, insbesondere von einem zentralen Server und/oder einem mobilen Gerät,
- Durchführen einer Fehlerortung an der Energieleitung, insbesondere durch Impulsreflexion.

In anderen Worten kann es vorgesehen sein, dass bei einer Aktivierung des Alarmprotokolls das Erstellen bzw. Bereitstellen wenigstens eines Fehlerdatensatzes durchgeführt wird. Die Erstellung eines Fehlerdatensatzes kann vorzugsweise durch eine Steuereinheit und/oder eine Auswerteeinheit und/oder eine Speichereinheit erfolgen. Wenigstens ein Fehlerdatensatz umfasst wenigstens einen Spannungswert sowie wenigstens einen Zeitstempel, wobei insbesondere jedem Spannungswert wenigstens ein, insbesondere genau ein, Zeitstempel zugeordnet ist. Dabei kann ein einem Spannungswert zugeordneter Zeitstempel charakteristisch sein für den Zeitpunkt, an dem der Spannungswert erfasst wurde.

Wenigstens ein Fehlerdatensatz kann mehrere Spannungswerte und/oder Zeitstempel umfassen. Insbesondere kann es vorgesehen sein, dass wenigstens ein Fehlerdatensatz mehrere Spannungswerte über einen zusammenhängenden Erfassungszeitraum umfasst. Hiermit ist gemeint, dass der Fehlerdatensatz alle in dem Erfassungszeitraum, insbesondere für eine Energieleitung, erfassten Spannungswerte und/oder Zeitstempel umfasst. Hierdurch ergibt sich der Vorteil, dass die erfassten Spannungswerte in einer übersichtlichen und leicht zugänglichen Datenstruktur gebündelt werden, um den Zugang zu relevanten Daten nachfolgend möglichst einfach und effizient zu gestalten. Es kann vorgesehen sein, dass der Erfassungszeitraum den Zeitraum wenigstens einer Stunde, wenigstens eines Tages (24 Stunden) oder wenigstens eines Kalendermonats abbildet. Es kann ferner vorgesehen sein, dass wenigstens ein Fehlerdatensatz nach der Erstellung, insbesondere einer Kommunikationseinheit, bereitgestellt wird. Die Bereitstellung kann bevorzugt erfolgen, um wenigstens einen Fehlerdatensatz an wenigstens einen zentralen Server oder wenigstens ein mobiles Gerät zu übertragen.

Wenigstens ein Fehlerdatensatz kann eine Teilmenge wenigstens eines Erfassungsdatensatzes abbilden. Insbesondere kann es vorgesehen sein, dass der Erfassungszeitraum wenigstens eines Fehlerdatensatzes kleiner ist als der Erfassungszeitraum wenigstens eines Erfassungsdatensatzes bzw. aller Erfassungsdatensätze. Hierdurch wird der Vorteil erzielt, dass die zur Auswertung eines in einer Energieleitung detektierten Fehlers übermittelten Datenmengen reduziert werden können. Insbesondere kann der Erfassungszeitraum wenigstens eines Fehlerdatensatzes, insbesondere aller Fehlerdatensätze, weniger als 2 Sekunden, vorzugsweise weniger als 1 Sekunde, bevorzugt weniger als 0,1 Sekunden, besonders bevorzugt weniger als 0,02 Sekunden, betragen. Durch einen kurzen Erfassungszeitraum kann die im Falle einer Übertragung eines Fehlerdatensatzes zu übertagende Datenmenge entsprechend reduziert werden.

Es ist ferner denkbar, dass wenigstens ein Erfassungsdatensatz und/oder wenigstens ein Fehlerdatensatz wenigstens eine der nachfolgenden Informationen umfasst:
- Eine Lokalisierungsinformation,
- Eine Leitungsinformation.

Hierdurch ergibt sich der Vorteil, dass der Erfassungsdatensatz und/oder der Fehlerdatensatz nicht nur Informationen über den zeitlichen Spannungsverlauf in einer Energieleitung umfasst, sondern ferner auch festgehalten wird, wo die Messinformationen erfasst wurden bzw. wo die betreffende Energieleitung zu finden ist und/oder um welche Energieleitung es sich genau handelt. Daher vereinfacht die Verwendung einer Lokalisierungsinformation und/oder Leitungsinformation eine anschließende Durchführung einer Fehlerortung und/oder von Reparaturmaßnahmen. In anderen Worten kann hierdurch realisiert werden, dass ein Erfassungsdatensatz und/oder ein Fehlerdatensatz für eine Energieleitung und/oder einen Erfassungsort spezifisch ist.

Alternativ oder zusätzlich kann es auch vorgesehen sein, dass Spannungswert eines Erfassungsdatensatzes und/oder eines Fehlerdatensatzes eine Lokalisierungsinformation und/oder eine Leitungsinformation zugeordnet ist.

Eine Lokalisierungsinformation kann für den Ort, an dem die in dem Erfassungsdatensatz und/oder Fehlerdatensatz hinterlegten Spannungswerte erfasst wurden, spezifisch sein. So kann eine Lokalisierungsinformation eine Standortinformation umfassen. Auch kann eine Lokalisierungsinformation einen Zeitstempel umfassen. Der Zeitstempel kann für den Zeitpunkt, an dem die Standortinformation erfasst wurde, spezifisch sein. Die Standortinformation kann als eine geografische Koordinateninformation ausgebildet sein. Eine Lokalisierungsinformation kann bspw. durch eine Lokalisierungseinheit erfasst werden. Wenigstens eine Lokalisierungseinheit kann einen Lokalisierungssensor umfassen, wobei der Lokalisierungssensor vorzugsweise zum Empfang eines Signals wenigstens eines globalen Navigationssatellitensystems, insbesondere NAVSTAR GPS, GLONASS, Galileo oder Beidou, ausgebildet ist. Somit kann die Lokalisierungsinformation bspw. einen Rückschluss darauf zulassen, in welchem Umspannwerk der betreffende Erfassungsdatensatz und/oder Fehlerdatensatz erfasst bzw. erstellt wurde. Hierdurch ergibt sich der Vorteil, dass auf einfache Weise die örtliche Zuständigkeit ermittelt und geschultes Personal einfach und unkompliziert an den Ort des erkannten Fehlers ausgesendet werden kann.

Eine Leitungsinformation kann für eine Energieleitung spezifisch sein. Eine Leitungsinformation kann eine Leitungskennung umfassen. Die Leitungskennung kann als eine numerische, alphabetische oder alpha-numerische Zeichenfolge ausgebildet sein. In anderen Worten kann es vorgesehen sein, dass sich über die Leitungsinformation eine Energieleitung eindeutig identifizieren lässt. Aus Umspannwerken werden mitunter mehrere Energieleitungen eines Mittelspannungsnetzes abgezweigt. Entsprechend ist es im Falle der Detektion einer Fehlfunktion einer Energieleitung nicht nur hilfreich zu wissen wo der Fehler detektiert wurde, sondern darüber hinaus auch, in welcher Leitung der Fehler detektiert wurde. Durch die Verwendung einer Leitungsinformation kann vor Ort somit einfach und eindeutig festgestellt werden, in welcher Leitung eine Fehlfunktion detektiert wurde und ggf. eine nachfolgende Fehlerortung durchgeführt werden muss. Es kann vorgesehen sein, dass die Leitungskennung vor Durchführung eines Verfahrens durch einen Benutzer definiert wird. Bspw. kann die Definition wenigstens einer Leitungskennung in einer Steuereinheit und/oder Auswerteeinheit erfolgen, sodass den durch die Erfassungseinheit erfassten Spannungswerten bzw. Erfassungsdatensätzen eine Leitungskennung zugeordnet werden kann. Auch kann es vorgesehen sein, dass die Leitungskennung unmittelbar aus der Energieleitung ausgelesen wird. Dies kann bspw. durch eine Auswerteeinheit erfolgen.

Ferner kann es im Rahmen der Erfindung vorgesehen sein, dass bei einer Aktivierung des Alarmprotokolls das Übertragen wenigstens eines Fehlerdatensatzes an einen zentralen Server und/oder an wenigstens ein mobiles Gerät, insbesondere durch eine Kommunikationseinheit, durchgeführt wird. Hierdurch wird es ermöglicht, dass die in Bezug auf einen in einer Energieleitung detektierten Fehler relevanten Daten für eine weitere Auswertung bzw. Analyse auf einem zentralen Server und/oder einem mobilen Gerät bereitgestellt werden. Die Auswertung eines Fehlerdatensatzes in wenigstens einem zentralen Server und/oder auf wenigstens einem mobilen Gerät kann zumindest teilweise automatisiert erfolgen und/oder zumindest teilweise manuell durch einen Benutzer erfolgen. Eine automatisierte Auswertung kann bspw. eine Filterung und/oder eine Glättung der in dem Fehlerdatensatz enthaltenen Daten umfassen. Es kann im Rahmen der Erfindung vorgesehen sein, dass die Übertragung wenigstens eines Fehlerdatensatzes zumindest teilweise drahtlos erfolgt. Zusätzlich oder alternativ kann es vorgesehen sein, dass die Übertragung wenigstens eines Fehlerdatensatzes zumindest teilweise drahtgebunden erfolgt. Im Rahmen einer drahtlosen Übertragung kann es vorgesehen sein, dass die Übertragung zumindest teilweise über Bluetooth, ein Wireless Local Area Network (WLAN), Troposphärenfunk (Troposcatter) und/oder Mobilfunk bzw. ein Mobilfunknetz erfolgt. Im Rahmen einer drahtgebundenen Übertragung kann es ferner vorgesehen sein, dass die Übertragung zumindest teilweise über ein Local Area Network (LAN) und/oder Power Line Communication erfolgt. Eine drahtlose Übertragung, insbesondere zumindest teilweise über ein Mobilfunknetz, bietet den Vorteil einer besonders einfachen Ausführung bei gleichzeitig schneller und weitgehend reichweitenunabhängiger Übertragung.

Ferner ist es im Rahmen der Erfindung denkbar, dass bei einer Aktivierung des Alarmprotokolls ein Empfangen wenigstens einer Betriebsanweisung erfolgt. Das Empfangen kann vorzugsweise durch eine Kommunikationseinheit erfolgen, wobei insbesondere die Betriebsanweisung von wenigstens einem zentralen Server und/oder wenigstens einem mobilen Gerät empfangen wird. Eine Betriebsanweisung kann wenigstens eine Anweisung zum Betrieb wenigstens einer Energieleitung umfassen. Ferner kann es vorgesehen sein, dass wenigstens eine Betriebsanweisung wenigstens eine Leitungsinformation umfasst, sodass eine Anweisung zum Betrieb einer Energieleitung der betreffenden Energieleitung zugeordnet werden kann. Es kann vorgesehen sein, dass wenigstens eine durch eine Kommunikationseinheit empfangene Betriebsanweisung einer Steuereinheit bereitgestellt wird, wobei die Steuereinheit zur Ausführung der Betriebsanweisung ausgebildet ist bzw. dazu ausgebildet, andere Einheiten, wie bspw. eine Erfassungseinheit, zur Ausführung einzelner Schritte zur Umsetzung einer Betriebsanweisung zu veranlassen.

Eine Betriebsanweisung kann bspw. wenigstens eine der folgenden Anweisungen umfassen:
- Anweisung zur Trennung der Energieversorgung wenigstens einer Energieleitung,
- Anweisung zum Durchführen einer Fehlerortung, insbesondere durch Impulsreflexion.

In anderen Worten kann es vorgesehen sein, dass die Betriebsanweisung eine Anweisung zur Trennung der Energieversorgung wenigstens einer Energieleitung umfasst. Dies kann insbesondere dann der Fall sein, wenn festgestellt wurde, dass eine in Bezug auf eine Energieleitung detektierte Fehlfunktion einen zumindest temporären sicheren Betrieb der Energieleitung gefährdet bzw. eine stärkere Beschädigung der Energieleitung kurz bevorsteht. Hierdurch kann es vorkommen, dass Endkunden zumindest temporär keine Energieversorgung erhalten. Meist kann die Ausfallzeit hierdurch dennoch insgesamt reduziert werden, da eine schlimmere Beschädigung der Energieleitung vermieden und der Aufwand zur Instandsetzung somit reduziert werden kann. Auch kann die Betriebsanweisung eine Anweisung zum Durchführen einer Fehlerortung umfassen. Hierdurch kann eine Lokalisierung des in der Energieleitung detektierten Fehlers erfolgen und nachfolgende Instandsetzungsarbeiten können effizient und zielgerichtet durchgeführt werden, ohne dass eine manuelle Fehlerortung durch entsprechendes Personal notwendig ist.

Ferner ist es denkbar, dass bei einer Aktivierung des Alarmprotokolls eine Fehlerortung an der Energieleitung durchgeführt wird. In anderen Worten kann es vorgesehen sein, dass die Fehlerortung automatisiert beim Auftreten eines Fehlers in der Energieleitung durchgeführt wird, ohne dass hierzu eine gesonderte Betriebsanweisung erforderlich ist.

Eine Fehlerortung kann durch Impulsreflexion erfolgen. Vorzugsweise werden im Rahmen der Fehlerortung elektrische Impulse in die betreffende Energieleitung eingebracht, welche an der Fehlerstelle in der Energieleitung zumindest teilweise reflektiert wird. Durch eine Laufzeitmessung des Impulses kann unter Verwendung der Ausbreitungsgeschwindigkeit des Impulses eine Lauflänge des Impulses in der Energieleitung bis zum Ort der Reflektion und somit eine Distanz des Fehlers in der Energieleitung vom Ort der Einbringung des Impulses in die Energieleitung ermittelt werden. Es kann im Rahmen der Erfindung vorgesehen sein, dass eine Erfassungseinheit und/oder eine Steuereinheit zur Durchführung einer Fehlerortung, insbesondere durch Impulsreflexion, ausgebildet ist.

Ferner kann es im Rahmen der Erfindung vorgesehen sein, dass wenigstens ein Fehlerdatensatz wenigstens zwei, vorzugsweise wenigstens drei, Spannungswerte in einem, insbesondere zusammenhängenden, Zeitintervall (Erfassungszeitraum) umfasst. In Bezug auf die vorliegende Erfindung ist es vorstellbar, dass ein Anfangszeitpunkt des Zeitintervalls bzw. Erfassungszeitraums durch ein Überschreiten des Spannungsgrenzwerts durch wenigstens einen Spannungswert festgelegt ist. Zusätzlich oder alternativ ist es vorstellbar, dass ein Endzeitpunkt des Zeitintervalls bzw. Erfassungszeitraums durch wenigstens eines der folgenden Ereignisse festgelegt ist:
- Unterschreiten des Spannungsgrenzwerts durch wenigstens einen Spannungswert, insbesondere durch wenigstens drei, insbesondere wenigstens fünf oder wenigstens zehn, aufeinanderfolgend erfasste Spannungswerte,
- Ablauf einer Zeitspanne ab dem Anfangszeitpunkt des Erfassungszeitraums, wobei die Zeitspanne wenigstens ein Viertel, vorzugsweise wenigstens die Hälfte, der Periodendauer der an der Energieleitung anliegenden Wechselspannung beträgt.

Durch eine solche Definition des Anfangs- bzw. Endzeitpunkt des Erfassungszeitraums eines Fehlerdatensatzes ergibt sich der Vorteil, dass einem Fehlerdatensatz nur diejenigen Werte des Spannungsverlaufs zugeordnet werden, welche für eine weitergehende Auswertung bzw. Analyse des Fehlers relevant sind.

Ferner kann es vorgesehen sein, dass insbesondere vor der Erfassung von Spannungswerten durch eine Erfassungseinheit eine Konfiguration wenigstens einer Erfassungseinheit durchgeführt wird. Die Konfiguration kann eine Zuordnung einer Leitungskennung zu der Erfassungseinheit umfassen. Hierdurch wird gekennzeichnet, für welche Energieleitung die Erfassungseinheit eine Erfassung von Spannungswerten durchführt. Die Konfiguration kann manuell durch einen Benutzer erfolgen. Auch kann die Leitungskennung automatisiert, insbesondere durch die Erfassungseinheit, aus der Energieleitung ausgelesen werden. Auch kann die Konfiguration unter Verwendung wenigstens eines mobilen Geräts und/oder eines zentralen Servers erfolgen, wobei die Leitungskennung von dem mobilen Gerät und/oder dem zentralen Server an die Erfassungseinheit übermittelt wird. Hierzu kann es vorgesehen sein, dass die Leitungskennung zunächst an eine Kommunikationseinheit übermittelt wird und von der Kommunikationseinheit, insbesondere über eine Steuereinheit, weiter an die Erfassungseinheit übermittelt wird.

Es kann ferner vorgesehen sein, dass bei einer Aktivierung eines Alarmprotokolls ein Aktivierungsdatensatz, insbesondere durch die Steuereinheit, angelegt und/oder zumindest temporär, insbesondere durch eine Speichereinheit und/oder auf einem Datenträger, gespeichert wird. Der Aktivierungsdatensatz kann wenigstens einen Zeitstempel umfassen, wobei der Zeitstempel für den Aktivierungszeitpunkt des Alarmprotokolls spezifisch ist. Ferner kann der Aktivierungsstempel eine Leitungsinformation umfassen. Hierdurch kann festgestellt werden, in welcher Energieleitung ein Fehler detektiert wurde bzw. für welche Energieleitung ein Alarmprotokoll aktiviert wurde. Durch das Speichern wenigstens eines Aktivierungsdatensatzes kann die Fehlerhistorie in Bezug auf eine Energieleitung bzw. mehrere Energieleitungen konsistent nachvollzogen werden.

Ferner kann wenigstens ein Aktivierungsdatensatz eine Aktivierungsinformation umfassen, wobei durch die Aktivierungsinformation angegeben wird ob das Alarmprotokoll noch aktiv ist. Hierdurch kann festgestellt werden, ob aktuell ein Alarmprotokoll für eine Energieleitung aktiviert wurde bzw. aktuell durchlaufen wird bzw. ob im Falle der Detektion eines Fehlerereignisses in einer Energieleitung ein neues Alarmprotokoll aktiviert werden soll oder nicht. Es kann vorgesehen sein, dass die Aktivierungsinformation bei Anlegen bzw. Erstellen eines Aktivierungsdatensatzes auf aktiv gesetzt wird, wobei aktiv meint, dass das Alarmprotokoll aktiviert wurde und aktuell keine erneute Aktivierung eines Alarmprotokolls erfolgen soll. Alternativ oder zusätzlich kann es vorgesehen sein, dass die Aktivierungsinformation nach Abschluss eines Alarmprotokolls und/oder bei Deaktivierung des Alarmprotokolls auf inaktiv gesetzt wurde, wobei inaktiv mein, dass das im Falle eines in einer Energieleitung detektierten Fehlerereignisses ein neues Alarmprotokoll aktiviert wird. Hierdurch ergibt sich der Vorteil, dass wenn mehrere, insbesondere aufeinanderfolgend erfasste, Spannungswerte den Spannungsgrenzwert übersteigen, nicht mehrere Alarmprotokolle aktiviert werden, sondern dieses Fehlerereignis in einem einzigen Alarmprotokoll bzw. Fehlerdatensatz gebündelt wird.

Es kann vorgesehen sein, dass die Aktivierungsinformation vor dem vollständigen Abschluss eines Alarmprotokolls bereits auf inaktiv gesetzt wird. So kann es bspw. vorgesehen sein, dass die Aktivierungsinformation mit dem Endzeitpunkt eines Erfassungszeitraums des dem Alarmprotokolls zugeordneten Fehlerdatensatzes auf inaktiv gesetzt wird. Dies hat den Vorteil, dass keine Totzeiträume entstehen, in denen Spannungswerte zwar erfasst, aber mögliche Fehler in einer Energieleitung nicht detektiert bzw. gemeldet werden.

Es kann im Rahmen der Erfindung vorgesehen sein, dass zur Erfassung der elektrischen Spannung auf einem Kabelschirm einer Energieleitung eines Mittelspannungsnetzes der Kabelschirm zumindest teilweise aus der Energieleitung herausgeführt wird. Hierzu kann es vorgesehen sein, dass eine äußere Isolierung der Energieleitung zumindest lokal aufgetrennt wird. So kann der Kabelschirm bzw. können die Schirmdrähte zu einem Leiter geformt (bspw. geflochten oder gezwirbelt) und für die Erfassung durch eine Erfassungseinheit zugänglich gemacht werden.

Es kann im Rahmen der Erfindung vorgesehen sein, dass die Erfassung von Spannungswerten auf einem Kabelschirm einer Energieleitung im Bereich eines Endverschlusses der Energieleitung durchgeführt wird. Der Endverschluss kann einen Übergang von dem betreffenden Energiekabel zu einem anknüpfenden Energiekabel oder einem Transformator bilden.

Die obenstehende Aufgabe wird ferner gelöst durch eine erfindungsgemäße Vorrichtung zur Überwachung wenigstens einer Energieleitung in einem Mittelspannungsnetz, umfassend:
- Wenigstens eine Erfassungseinheit zur Erfassung von Spannungswerten durch eine zeitdiskrete Erfassung der elektrischen Spannung auf einem Kabelschirm der Energieleitung,
- Wenigstens eine Auswerteeinheit zur Auswertung wenigstens eines Spannungswerts,
- Wenigstens eine Steuereinheit zur Aktivierung eines Alarmprotokolls, sofern der Spannungsgrenzwert durch wenigstens einen der erfassten Spannungswerte überschritten wurde.

In Bezug auf eine erfindungsgemäße Vorrichtung ergeben sich die gleichen Vorteile, wie sie bereits in Bezug auf ein erfindungsgemäßes Verfahren beschrieben worden sind.

Es kann im Rahmen der Erfindung vorgesehen sein, dass durch eine Erfassungseinheit die elektrische Spannung in wenigstens einer, insbesondere genau einer, Energieleitung bzw. auf wenigstens einem, insbesondere genau einem, Kabelschirm, erfassbar ist. Entsprechend ist es denkbar, dass eine Vorrichtung wenigstens zwei bzw. mehrere Erfassungseinheiten umfasst, wobei jeweils eine Erfassungseinheit zur Erfassung der elektrischen Spannung auf dem Kabelschirm jeweils einer Energieleitung ausgebildet ist.

Es kann vorgesehen sein, dass wenigstens eine Erfassungseinheit zur, insbesondere zeitlich diskreten, Erfassung der elektrischen Spannung in wenigstens einer Energieleitung wenigstens einen Spannungswandler umfasst. Der Spannungswandler kann zumindest abschnittsweise ringförmig, insbesondere. als ein Durchsteckwandler oder Umbauwandler ausgebildet sein, sodass eine Energieleitung zumindest abschnittsweise durch den Spannungswandler hindurchführbar ist. Hierdurch ergibt sich der Vorteil, dass eine Erfassung der elektrischen Spannung bei bereits existierenden Energieleitungen durchführbar ist. Die Messung der Spannung kann bevorzugt induktiv und/oder kapazitiv erfolgen.

Wenigstens eine Erfassungseinheit und/oder wenigstens eine Auswerteeinheit und/oder wenigstens eine Speichereinheit und/oder wenigstens eine Steuereinheit kann derart ausgebildet sein, dass zumindest zeitweise eine Kommunikationsverbindung, insbesondere wenigstens zur Übertragung erfasster Spannungswerte, zwischen wenigstens einer Erfassungseinheit und wenigstens einer Auswerteeinheit und/oder wenigstens einer Speichereinheit und/oder wenigstens einer Steuereinheit herstellbar ist.

Es kann im Rahmen der Erfindung vorgesehen sein, dass wenigstens eine Auswerteeinheit zur Auswertung Spannungswerte mehrerer Erfassungseinheiten ausgebildet ist. So ist es bspw. denkbar, dass die Erfassung der Spannungswerte in mehreren Energieleitungen durch jeweils eine Erfassungseinheit erfolgt, die erfassten Daten jedoch in einer zentralen Auswerteeinheit ausgewertet werden. In diesem Zusammenhang kann es vorgesehen sein, dass die Auswerteeinheit dazu ausgebildet ist die Auswertung der durch unterschiedliche Erfassungseinheiten erfassten Spannungswerte parallel durchzuführen.

Wenigstens eine Auswerteeinheit und/oder wenigstens eine Steuereinheit kann derart ausgebildet sein, dass zumindest zeitweise eine Kommunikationsverbindung, insbesondere wenigstens zur Übertragung eines Auswerteergebnisses, zwischen wenigstens einer Auswerteeinheit und wenigstens einer Steuereinheit herstellbar ist.

Im Rahmen der Erfindung kann es von Vorteil sein, dass die Vorrichtung zusätzlich wenigstens eine der folgenden Einheiten umfasst:
- Wenigstens eine Kommunikationseinheit, insbesondere zur Übertragung wenigstens eines Fehlerdatensatzes an wenigstens einen zentralen Server und/oder wenigstens ein mobiles Gerät,
- wenigstens eine Speichereinheit zur zumindest temporären Speicherung wenigstens eines Erfassungsdatensatzes und/oder wenigstens eines Fehlerdatensatzes und/oder wenigstens einer Aktivierungsinformation,
- wenigstens eine Lokalisierungseinheit zur Erfassung wenigstens einer Standortinformation.

Wenigstens eine Kommunikationseinheit kann wenigstens eine drahtlose und/oder wenigstens eine drahtgebundene Kommunikationsschnittstelle aufweisen. Wenigstens eine drahtlose Kommunikationsschnittstelle kann als eine Bluetooth-Schnittstelle, WLAN-Schnittstelle, Troposcatter-Schnittstelle oder Mobilfunkschnittstelle ausgebildet sein.

Wenigstens eine Speichereinheit kann wenigstens einen Datenspeicher umfassen. Wenigstens ein Datenspeicher kann vorzugsweise als ein nichtflüchtiger Datenspeicher, insbesondere als SSD (Solid-State-Drive) oder Flash-Speicher oder ein magnetisches Speichermedium wie ein HDD-Speicher (Hard-Disk-Drive) ausgebildet sein.

Wenigstens eine Lokalisierungseinheit kann wenigstens einen Lokalisierungssensor umfassen. Der Lokalisierungssensor kann zum Empfang wenigstens eines Satellitensignals eines globalen Satellitennavigationssystems, vorzugsweise NAVSTAR GPS, GLONASS, Galileo oder Beidou, ausgebildet sein.

Es ist ferner denkbar, dass wenigstens zwei Einheiten aus der Gruppe Erfassungseinheit, Auswerteeinheit, Steuereinheit, Kommunikationseinheit, Speichereinheit, Lokalisierungseinheit dazu ausgebildet sind, zumindest temporär eine, vorzugsweise wechselseitige, Kommunikationsverbindung herstellen zu können. Die Kommunikationsverbindung kann zur Übertragung von Datensätzen zwischen den genannten Einheiten dienen.

Es kann im Rahmen der Erfindung vorgesehen sein, dass wenigstens zwei Einheiten aus der Gruppe Erfassungseinheit, Auswerteeinheit, Steuereinheit, Kommunikationseinheit, Speichereinheit, Lokalisierungseinheit als eine gemeinsame Einheit ausgebildet sind. Zusätzlich oder alternativ kann es vorgesehen sein, dass wenigstens zwei Einheiten aus der Gruppe Erfassungseinheit, Auswerteeinheit, Steuereinheit, Kommunikationseinheit, Speichereinheit, Lokalisierungseinheit auf einer gemeinsamen Leiterplatte angeordnet sind.

Eine zumindest temporäre Kommunikation zwischen wenigstens zwei Einheiten aus der Gruppe Erfassungseinheit, Auswerteeinheit, Steuereinheit, Kommunikationseinheit, Speichereinheit, Lokalisierungseinheit kann zumindest teilweise drahtlos und/oder zumindest teilweise drahtgebunden erfolgen. Insbesondere ist es denkbar, dass die Kommunikation zwischen wenigstens zwei Einheiten aus der Gruppe Erfassungseinheit, Auswerteeinheit, Steuereinheit, Kommunikationseinheit, Speichereinheit, Lokalisierungseinheit über Leiterbahnen einer gemeinsamen Leiterplatte erfolgt.

Es kann im Rahmen der Erfindung ferner vorgesehen sein, dass wenigstens eine Vorrichtung wenigstens zwei Erfassungseinheiten umfasst, wobei jede der Erfassungseinheiten zur Erfassung von Spannungswerten bzw. der elektrischen Spannung auf dem Kabelschirm einer Energieleitung ausgebildet ist

Auch ist es denkbar, dass die Vorrichtung nach einem erfindungsgemäßen Verfahren betreibbar ist. Insbesondere kann es vorgesehen sein, dass die Vorrichtung nach einem erfindungsgemäßen Verfahren, insbesondere nach einem Verfahren gemäß einem der Ansprüche 1 bis 9, betreibbar ist.

Es kann im Rahmen der Erfindung vorgesehen sein, dass wenigstens eine Erfassungseinheit, wenigstens eine Auswerteeinheit, wenigstens eine Steuereinheit, wenigstens eine Lokalisierungseinheit, wenigstens eine Kommunikationseinheit und/oder wenigstens eine Speichereinheit Mittel zur Datenverarbeitung, insbesondere wenigstens einen Prozessor und/oder wenigstens einen Arbeitsspeicher umfasst. Insbesondere kann es vorgesehen sein, dass wenigstens eine der genannten Einheiten dazu ausgebildet ist Code-Anweisungen auszuführen. Bei den Code-Anweisungen kann es sich um Anweisungen gemäß einem erfindungsgemäßen Computerprogrammprodukt handeln.

Die obenstehende Aufgabe wird ferner gelöst durch ein erfindungsgemäßes Umspannwerk, umfassend wenigstens einen Transformator zur Umwandlung von Hochspannung in Mittelspannung und/oder wenigstens einen Transformator zur Umwandlung von Mittelspannung in Niederspannung sowie wenigstens eine erfindungsgemäße Vorrichtung, insbesondere wenigstens eine Vorrichtung nach einem der Ansprüche 10 bis 11, wobei die Vorrichtung derart in dem Umspannwerk angeordnet ist, dass wenigstens eine zumindest abschnittsweise in dem Umspannwerk angeordnete Energieleitung eines Mittelspannungsnetzes durch die Vorrichtung überwachbar ist. Wenigstens ein Transformator kann eine Schnittstelle bzw. einen Übergang zwischen einem Mittelspannungsnetz und einem Niederspannungsnetz oder eine Schnittstelle bzw. einen Übergang zwischen einem Mittelspannungsnetz und einem Hochspannungsnetz bilden. Es ergeben sich die gleichen Vorteile, wie sie bereits in Bezug auf ein erfindungsgemäßes Verfahren und/oder eine erfindungsgemäße Vorrichtung beschrieben wurden.

Die obenstehende Aufgabe wird ferner gelöst durch ein erfindungsgemäßes System zur Überwachung wenigstens einer Energieleitung in einem Mittelspannungsnetz, umfassend wenigstens eine erfindungsgemäße Vorrichtung, insbesondere wenigstens eine Vorrichtung nach einem der Ansprüche 10 bis 11, und/oder wenigstens ein erfindungsgemäßes Umspannwerk, insbesondere wenigstens ein Umspannwerk nach Anspruch 12, sowie wenigstens einen zentralen Server und/oder wenigstens ein mobiles Gerät. Es kann im Rahmen der Erfindung vorgesehen sein, dass das System, insbesondere wenigstens eine Vorrichtung des Systems, nach einem erfindungsgemäßen Verfahren, insbesondere einem Verfahren gemäß einem der Ansprüche 1 bis 9, betreibbar ist. Durch ein erfindungsgemäßes System zur Überwachung wenigstens einer Energieleitung ergeben sich die gleichen Vorteile wie sie bereits in Bezug auf ein erfindungsgemäßes Verfahren, eine erfindungsgemäße Vorrichtung und ein erfindungsgemäßes Umspannwerk beschrieben wurden.

Wenigstens ein mobiles Gerät kann im Rahmen der vorliegenden Erfindung als ein Mobiltelefon, insbesondere als ein Smartphone, oder als ein Tablet oder als ein Laptop ausgebildet sein. Auch kann wenigstens ein mobiles Gerät als eine Smartwatch ausgebildet sein.

Es kann vorgesehen sein, dass wenigstens ein zentraler Server wenigstens einen Rechner umfasst. Insbesondere kann es vorgesehen sein, dass ein zentraler Server mehrere Rechner umfasst, welche über ein Netzwerk miteinander verbunden sind. Es kann im Rahmen der Erfindung vorgesehen sein, dass durch den zentralen Server bzw. durch wenigstens einen zentralen Server ein Cloud-System ausgebildet wird. Wenigstens ein zentraler Server kann dazu ausgebildet sein, zumindest temporär mit einer erfindungsgemäßen Vorrichtung und/oder wenigstens einem mobilen Gerät, insbesondere über ein Netzwerk (bspw. das Internet) und/oder ein Mobilfunknetz, zu kommunizieren.

Die obenstehende Aufgabe wird ferner gelöst durch ein erfindungsgemäßes Computerprogrammprodukt, umfassend Befehle, die bewirken, dass eine erfindungsgemäße Vorrichtung, insbesondere eine Vorrichtung gemäß einem der Ansprüche 9 bis 10, ein erfindungsgemäßes Verfahren, insbesondere ein Verfahren gemäß einem der Ansprüche 1 bis 8, ausführt.

Die obenstehende Aufgabe wird ferner gelöst durch ein erfindungsgemäßes Computerlesbares Speichermedium, auf dem ein erfindungsgemäßes Computerprogrammprodukt, insbesondere ein Computerprogrammprodukt nach Anspruch 10, gespeichert ist.

Weitere Vorteile, Merkmale und Einzelheiten der Erfindung ergeben sich aus der nachfolgenden Beschreibung, in der unter Bezugnahme auf die Zeichnungen mehrere Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Dabei zeigt
- Fig. 1: eine schematische Darstellung eines Energieversorgungsnetzes,
- Fig. 2: eine schematische Darstellung eines Energiekabels eines Mittelspannungsnetzes,
- Fig. 3: eine schematische Darstellung einer erfindungsgemäßen Vorrichtung,
- Fig. 4: eine schematische Darstellung eines erfindungsgemäßen Umspannwerks,
- Fig. 5: eine schematische Darstellung eines erfindungsgemäßen Systems,
- Fig. 6: eine schematische Darstellung eines erfindungsgemäßen Verfahrens und
- Fig. 7: eine schematische Darstellung eines exemplarischen Spannungsverlaufs.

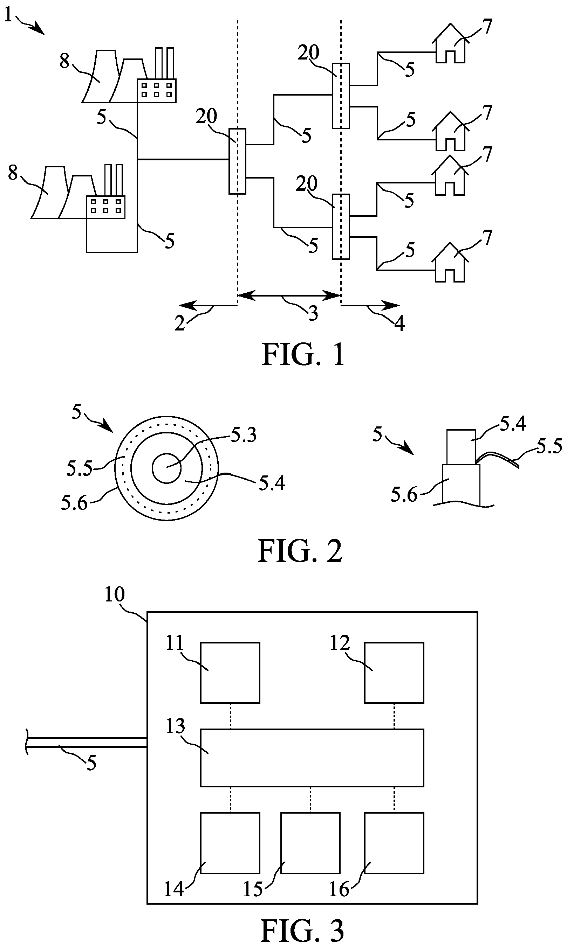

Fig. 1 zeigt eine schematische Darstellung eines Energieversorgungsnetzes 1 zur Energieversorgung von Haushalten und Industriebetrieben (Endkunden 7). Das Energieversorgungsnetz 1 umfasst mehrere Spannungsebenen. Gezeigt sind ein Hochspannungsnetz 2, ein Mittelspannungsnetz 3 sowie ein Niederspannungsnetz 4. Durch das Hochspannungsnetz 2 erfolgt eine überregionale Verteilung des elektrischen Stroms ausgehend von den Energieerzeugern 8. Vorliegend sind die Energieerzeuger 8 als Kraftwerke dargestellt. Mögliche Kraftwerksformen sind bspw. Kohle-, Gas- oder Kernkraftwerke. Die Energieerzeuger 8 können jedoch auch Energieerzeuger 8 sein, welche regenerative Energien wie Solarenergie, Windenergie oder Wasserkraft nutzen.

Eine an das Hochspannungsnetz 2 anschließende regionale Unterverteilung erfolgt in dem Mittelspannungsnetz 3, wobei die Umwandlung der elektrischen Spannung von Hoch- auf Mittelspannung durch ein Umspannwerk 20 erfolgt. Die Belieferung der Endkunden 7 erfolgt schließlich über das an das Mittelspannungsnetz 3 anschließende Niederspannungsnetz 4. Die Umwandlung von Mittelspannung auf Niederspannung erfolgt ebenfalls durch Umspannwerke 20. Alternativ kann die Umwandlung von Mittelspannung auf Niederspannung auch in einer Transformatorenstation erfolgen. Das Hochspannungsnetz, das Mittelspannungsnetz 3 und das Niederspannungsnetz 4 umfassen jeweils mehrere Energieleitungen 5.

Fig. 2 zeigt eine schematische Darstellung einer Energieleitung 5 eines Mittelspannungsnetzes. Dabei ist die Energieleitung 5 auf der linken Seite der Fig. 2 im Querschnitt dargestellt. Die Energieleitung 5 umfasst einen Innenleiter 5.3. Der Innenleiter 5.3 ist zumindest abschnittsweise ummantelt bzw. umhüllt von einem Isolationsmaterial 5.4. Ferner umfasst die Energieleitung 5 einen Kabelschirm, wobei der Innenleiter 5.3 und das Isolationsmaterial zumindest abschnittsweise von dem Kabelschirm 5.5 ummantelt sind. Der Innenleiter 5.3 ist als ein Drahtgeflecht ausgebildet. Ferner umfasst die Energieleitung 5 eine Außenisolierung 5.6, welche die Energieleitung 5 vor Umgebungseinflüssen wie Feuchtigkeit schützt.

In Fig. 2 ist ferner eine schematische Seitenansicht einer Energieleitung 5 dargestellt, wobei die Außenisolierung 5.6 zumindest abschnittsweise geöffnet und die Schirmdrähte des Kabelschirms 5.5 zu einem Leiter geformt (bspw. geflochten oder gezwirbelt) wurden. In anderen Worten wurde der Kabelschirm 5.5 zumindest lokal aus dem Energiekabel herausgeführt, um eine Erfassung der elektrischen Spannung auf dem Kabelschirm 5.5 (durch eine Erfassungseinheit 11) zu ermöglichen.

Fig. 3 zeigt eine schematische Darstellung einer erfindungsgemäßen Vorrichtung 10 zur Überwachung einer Energieleitung 5, wobei die Überwachung im Bereich eines nicht näher dargestellten Endverschlusses der Energieleitung 5 erfolgt. Die gezeigte Energieleitung 5 ist Teil eines Mittelspannungsnetzes 3. Die Vorrichtung 10 umfasst eine Erfassungseinheit 11 zur zeitdiskreten Erfassung der elektrischen Spannung auf dem Kabelschirm 5.5 der Energieleitung 5. Ferner umfasst die Vorrichtung 10 eine Auswerteeinheit 12 zur Auswertung wenigstens eines durch die Erfassungseinheit 11 erfassten Spannungswerts. Auch ist eine Steuereinheit 13 durch die Vorrichtung 10 umfasst, wobei die Steuereinheit 13 wenigstens zur Aktivierung eines Alarmprotokolls ausgebildet ist.

Ferner umfasst die Vorrichtung 10 gemäß Fig. 3 eine Kommunikationseinheit 14 zur Übertragung wenigstens eines Fehlerdatensatzes an wenigstens einen zentralen Server 18 und/oder an wenigstens ein mobiles Gerät 17. Zusätzlich umfasst ist eine Speichereinheit 15 zur zumindest temporären Speicherung wenigstens eines Erfassungsdatensatzes und/oder wenigstens eines Fehlerdatensatzes und/oder wenigstens eines Aktivierungsdatensatzes. Ferner ist eine Lokalisierungseinheit 16 durch die Vorrichtung 10 umfasst, wobei die Lokalisierungseinheit 16 zur Erfassung wenigstens einer Standortinformation ausgebildet ist.

In Fig. 3 ist durch die gestrichelten Linien dargestellt, dass zwischen der Steuereinheit 13 und den anderen durch die Vorrichtung 10 umfassten Einheiten 11, 12, 14, 15, 16 zumindest temporär eine, vorzugsweise wechselseitige, Kommunikationsverbindung herstellbar ist. Die Kommunikationsverbindung ist dazu ausgebildet, Datensätze, insbesondere Fehlerdatensätze und/oder Erfassungsdatensätze und/oder Aktivierungsdatensätze, und/oder Informationen, insbesondere Lokalisierungsinformationen, Leitungsinformationen und/oder Aktivierungsinformationen, und/oder Betriebsanweisungen zu versenden, bereitzustellen und/oder zu empfangen.

Vorliegend dient die Steuereinheit 13 gemäß Fig. 3 als zentrale Schnittstelle zur vorrichtungsinternen Kommunikation zwischen den umfassten Einheiten 11, 12, 13, 14, 15, 16. Es kann jedoch ebenfalls im Rahmen der Erfindung vorgesehen sein, dass einzelne Einheiten (bspw. die Erfassungseinheit 11 und die Auswerteeinheit 12) unmittelbar miteinander kommunizieren.

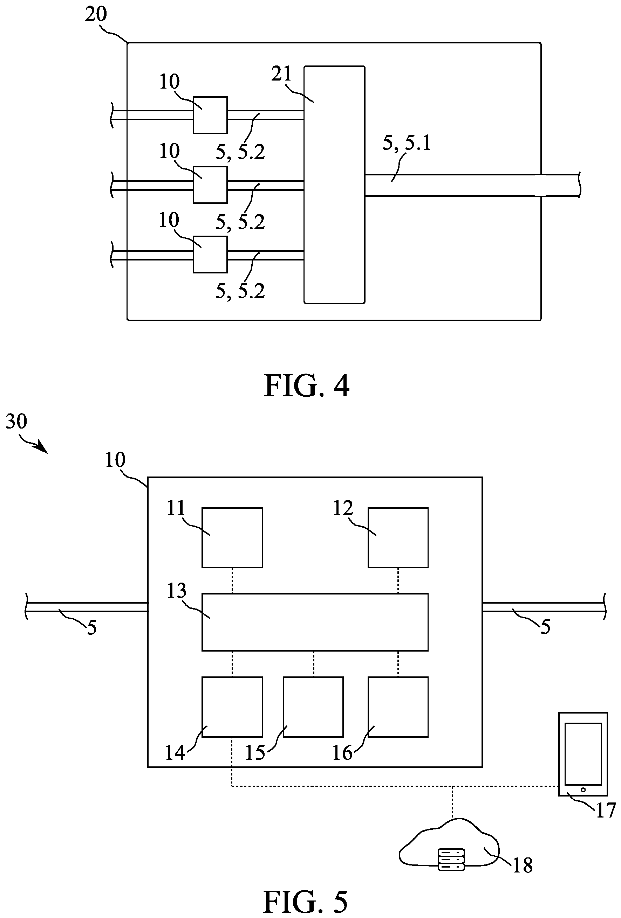

Fig. 4 zeigt eine schematische Darstellung eines erfindungsgemäßen Umspannwerks 20. Das Umspannwerk 20 umfasst wenigstens einen Transformator 21 zur Umwandlung von Hochspannung in Mittelspannung. Das Umspannwerk 20 bildet somit eine Schnittstelle bzw. einen Übergang zwischen einem Mittelspannungsnetz 3 und einem Hochspannungsnetz 2.

In dem Umspannwerk 20 ist wenigstens abschnittsweise zumindest eine erste Energieleitung 5.1 angeordnet bzw. mit dem Transformator 21 verbunden, wobei die erste Energieleitung 5.1 eine Energieleitung 5 eines Hochspannungsnetzes 2 ist. Ferner ist in dem Umspannwerk 20 zumindest abschnittsweise wenigstens eine zweite Energieleitung 5.2 angeordnet bzw. mit dem Transformator 21 verbunden, wobei die zweite Energieleitung 5.2 eine Energieleitung 5 eines Mittelspannungsnetzes 3 ist. Das Umspannwerk 20 umfasst ferner wenigstens eine erfindungsgemäße Vorrichtung 10, wobei die Vorrichtung 10 derart angeordnet ist, dass wenigstens eine zumindest abschnittsweise in dem Umspannwerk 20 angeordnete Energieleitung 5 eines Mittelspannungsnetzes 3 durch die Vorrichtung 10 überwachbar ist. Vorliegend sind drei zweite Energieleitungen 5.2 eines Mittelspannungsnetzes 3 dargestellt, wobei jeder der zweiten Energieleitungen 5.2 des Mittelspannungsnetzes 3 jeweils eine Vorrichtung 10 zur Überwachung der jeweiligen Energieleitung 5 zugeordnet ist.

Fig. 5 zeigt ein erfindungsgemäßes System 30 zur Überwachung wenigstens einer Energieleitung 5 in einem Mittelspannungsnetz 3. Die Fig. 5 zeigt die Vorrichtung 10 der Fig. 3, wobei durch das System 30 neben der Vorrichtung 10 wenigstens ein zentraler Server 18 und/oder wenigstens ein mobiles Gerät 17 umfasst ist. Wie durch die gestrichelten Linien dargestellt, kann es vorgesehen sein, dass die Vorrichtung 10, insbesondere die Kommunikationseinheit 14 der Vorrichtung 10, dazu ausgebildet ist zumindest temporär eine, insbesondere wechselseitige, Kommunikationsverbindung zu dem mobilen Gerät 17 und/oder dem zentralen Server 18 herstellen zu können. Über eine solche Kommunikationsverbindung können Datensätze und/oder Informationen und/oder Betriebsanweisungen zwischen der Vorrichtung 10 und dem zentralen Server 18 und/oder dem mobilen Gerät 17 ausgetauscht bzw. übertragen werden. Die in Fig. 4 dargestellte Vorrichtung 10 kann in einem Umspannwerk 20 (bspw. gemäß Fig. 4) angeordnet sein.

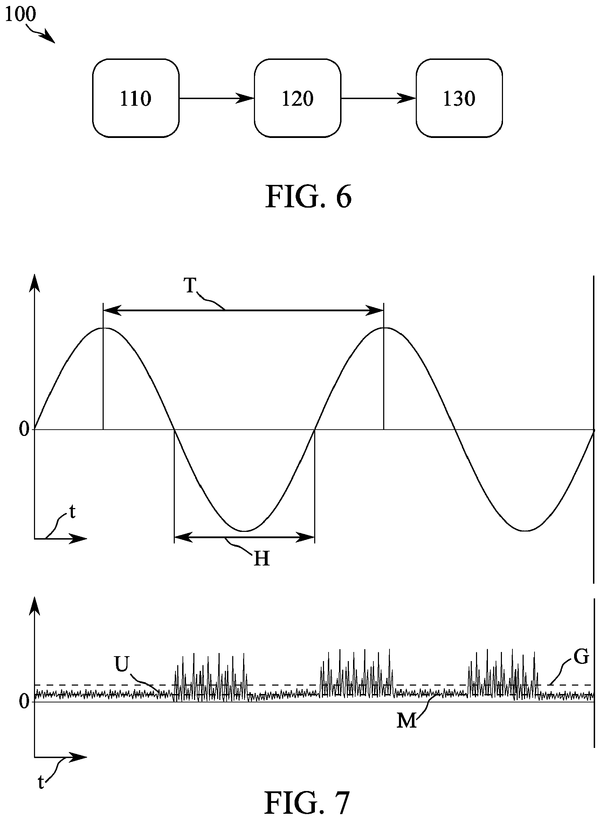

Fig. 6 zeigt ferner eine schematische Darstellung eines erfindungsgemäßen Verfahrens 100 zur Überwachung wenigstens einer Energieleitung 5 eines Niederspannungsnetzes 4 wobei an der Energieleitung 5 zumindest temporär eine, vorzugsweise sinusförmige, elektrische Wechselspannung mit einer ersten Frequenz anliegt, das Verfahren 100 wenigstens umfassend:
- Erfassen 110 von Spannungswerten U durch eine zeitdiskrete Erfassung der elektrischen Spannung auf dem Kabelschirm 5.5 der Energieleitung 5, wobei die Erfassung der Spannungswerte U mit einer zweiten Frequenz erfolgt, wobei die zweite Frequenz zur Erfassung der Spannungswerte U höher ist als die erste Frequenz der Wechselspannung und wobei das Erfassen 110 der Spannungswerte U für hochfrequente Spannungsanteile in einem Frequenzband erfolgt, wobei das Frequenzband durch eine untere Grenze und eine obere Grenze begrenzt ist, wobei die untere Grenze wenigstens 1 kHz beträgt und die obere Grenze höchstens 100 kHz beträgt,
- Auswerten 120 wenigstens eines Spannungswerts U, das Auswerten 120 umfassend einen Vergleich der des Spannungswerts U mit einem Spannungsgrenzwert G,
- Aktivieren 130 eines Alarmprotokolls, sofern der Spannungsgrenzwert G durch wenigstens einen der erfassten Spannungswerte U überschritten wurde.

Fig. 7 zeigt ferner eine schematische Darstellung eines exemplarischen Spannungsverlaufs in einer Energieleitung 5 eines Mittelspannungsnetzes 3 im oberen Bereich sowie einen exemplarischen Spannungsverlauf auf dem Kabelschirm 5.5 der Energieleitung 5 im Falle eines Fehlers, insbesondere einer Teilentladung, in der Energieleitung. Aufgetragen sind die ist jeweils die elektrische Spannung über der Zeit t. Der Übersicht halber sind die auf dem Kabelschirm 5.5 erfassten Spannungswerte U als Linie aufgetragen. Es ergibt sich aus den vorhergehenden Ausführungen, dass sich die hier gezeigten Linien aus zeitlich diskreten Messwerten für die Spannung (Spannungswerte) ergeben.

Aus Fig. 7 wird ersichtlich, dass die an der Energieleitung 5 anliegende Spannung eine sinusförmige Wechselspannung mit einem zeitlich periodischen Verlauf ist. Die Frequenz der Wechselspannung ergibt sich dabei als Kehrwert der in Fig. 6 dargestellten Periodendauer T der Wechselspannung. Eine Halbschwingung H der Wechselspannung ist ebenfalls gekennzeichnet.

Entsprechend der Fig. 7 erfolgt im Rahmen eines erfindungsgemäßen Verfahrens 100 eine Erfassung von Spannungswerten U durch eine zeitdiskrete Erfassung der elektrischen Spannung auf dem Kabelschirm 5.5 einer Energieleitung 5 eines Mittelspannungsnetzes. Ferner erfolgt die Auswertung wenigstens eines Spannungswerts, wobei die Auswertung einen Vergleich Spannungswerts U mit einem Spannungsgrenzwert G umfasst. Sofern der Stromstärkegrenzwert G durch wenigstens einen erfassten Spannungswert U überschritten wurde, wird ein Alarmprotokoll aktiviert.

Der Spannungsgrenzwert G ist definiert als ein Vielfaches des zeitlichen Mittelwerts M des Grundrauschens der elektrischen Spannung auf dem Kabelschirm, wobei das Grundrauschen während eines fehlerfreien Betriebs der Energieleitung 5 erfassbar ist.

Es wird aus Fig. 7 ersichtlich, dass die Teilentladung in der Energieleitung 5 in einer Halbwelle der Spannung erfolgt. Die Teilentladung zeigt sich durch einen Anstieg der hochfrequenten elektrischen Spannung auf dem Kabelschirm. Beim nächsten Nulldurchgang der Wechselspannung ist Spannung auf dem Kabelschirm 5.5 jedoch bereits wieder auf ihr Ausgangsniveau zurückgekehrt. Es wurde im Rahmen der Erfindung festgestellt, dass sich schwerwiegende Kabelfehler in einer Energieleitung 5 durch ein solches Verhalten ankündigen können. Da Teilentladungen zeitlich sehr begrenzt erfassbar sind, ist es vorgesehen, dass die Erfassungsfrequenz zur Erfassung der Spannungswerte U größer ist als die Frequenz der Wechselspannung. Hierdurch können Fehlerereignisse wie bspw. in Fig. 7 zuverlässig erkannt werden. Entsprechend kann durch die vorliegende Erfindung der zuverlässige und stabile Betrieb eines Niederspannungsnetzes 4 auf einfache Weise sichergestellt werden.

### Bezupszeichenliste

- 1: Energieversorgungsnetz
- 2: Hochspannungsnetz
- 3: Mittelspannungsnetz
- 4: Niederspannungsnetz
- 5: Energieleitung
- 5.1: Erste Energieleitung
- 5.2: Zweite Energieleitung
- 5.3: Innenleiter
- 5.4: Isolationsmaterial
- 5.5: Kabelschirm
- 5.6: Außenisolierung
- 7: Endkunde
- 8: Energieerzeuger

- 10: Vorrichtung
- 11: Erfassungseinheit
- 12: Auswerteeinheit
- 13: Steuereinheit
- 14: Kommunikationseinheit
- 15: Speichereinheit
- 16: Lokalisierungseinheit
- 17: Mobiles Gerät
- 18: Zentraler Server

- 20: Umspannwerk
- 21: Transformator

- 30: System

- 100: Verfahren
- 110: Erfassen
- 120: Auswerten
- 130: Aktivieren

- G: Spannungsgrenzwert
- H: Halbschwingung
- M: zeitlicher Mittelwert
- T: Periodendauer
- t: Zeit
- U: Spannungswert

## Patentansprüche

1. Verfahren (100) zur Überwachung wenigstens einer Energieleitung (5) in einem Mittelspannungsnetz (3), die Energieleitung (5) wenigstens umfassend einen Innenleiter (5.3) sowie wenigstens einen Kabelschirm (5.5), wobei der Innenleiter (5.3) zumindest abschnittsweise von dem Kabelschirm (5.5) ummantelt ist und wobei an dem Innenleiter (5.3) zumindest temporär eine, vorzugsweise sinusförmige, elektrische Wechselspannung mit einer ersten Frequenz anliegt, das Verfahren (100) wenigstens umfassend:
- Erfassen (110) von Spannungswerten (U) durch eine zeitdiskrete Erfassung der elektrischen Spannung auf dem Kabelschirm (5.5) der Energieleitung (5), wobei die Erfassung der Spannungswerte (U) mit einer zweiten Frequenz erfolgt, wobei die zweite Frequenz zur Erfassung der Spannungswerte (U) höher ist als die erste Frequenz der Wechselspannung und wobei das Erfassen (110) der Spannungswerte (U) für hochfrequente Spannungsanteile in einem Frequenzband erfolgt, wobei das Frequenzband durch eine untere Grenze und eine obere Grenze begrenzt ist, wobei die untere Grenze wenigstens 1 kHz beträgt und die obere Grenze höchstens 100 kHz beträgt,
- Auswerten (120) wenigstens eines Spannungswerts (U), das Auswerten (120) umfassend einen Vergleich der des Spannungswerts (U) mit einem Spannungsgrenzwert (G),
- Aktivieren (130) eines Alarmprotokolls, sofern der Spannungsgrenzwert (G) durch wenigstens einen der erfassten Spannungswerte (U) überschritten wurde.

2. Verfahren (100) nach Anspruch 1,
**dadurch gekennzeichnet,**
**dass** die zweite Frequenz zur Erfassung der Spannungswerte (U) wenigstens das Zweifache der oberen Grenze des Frequenzbandes beträgt.

3. Verfahren (100) nach einem der vorhergehenden Ansprüche,
**dadurch gekennzeichnet,**
**dass** zusätzlich umfasst ist:
- Ermittlung des Spannungsgrenzwerts (G) durch Ermittlung eines zeitlichen Mittelwerts eines Grundrauschens der elektrischen Spannung auf dem Kabelschirm (5.5), insbesondere im fehlerfreien Betrieb der Energieleitung (5), wobei der Spannungsgrenzwert (G) ein Vielfaches, insbesondere wenigstens das 1,5-fache oder wenigstens das Zweifache, des zeitlichen Mittelwerts des Grundrauschens beträgt.

4. Verfahren (100) nach einem der vorhergehenden Ansprüche,
**dadurch gekennzeichnet,**
**dass** zusätzlich wenigstens eines der folgenden umfasst ist:
- Erstellen wenigstens eines Erfassungsdatensatzes, umfassend wenigstens einen Spannungswert (U) sowie wenigstens einen Zeitstempel, wobei jedem Spannungswert (U) in dem Erfassungsdatensatz ein Zeitstempel zugeordnet ist.
- Speichern wenigstens eines Erfassungsdatensatzes, wobei insbesondere jedem Erfassungsdatensatz ein übergeordneter Zeitstempel zugeordnet ist,
- Berechnen einer Zeitdifferenz zwischen wenigstens einem in einem Erfassungsdatensatz enthaltenen Zeitstempel und einem Referenzzeitstempel und Löschen des dem Zeitstempel zugeordneten Spannungswertes (U), sofern die Zeitdifferenz einen Zeitgrenzwert überschreitet
und/oder
Berechnen einer Zeitdifferenz zwischen wenigstens einem übergeordneten Zeitstempel eines Erfassungsdatensatzes und einem Referenzzeitstempel und Löschen des dem übergeordneten Zeitstempel zugeordneten Erfassungsdatensatzes, sofern die Zeitdifferenz einen Zeitgrenzwert überschreitet.

5. Verfahren (100) nach Anspruch 4,
**dadurch gekennzeichnet,**
**dass** wenigstens ein Erfassungsdatensatz wenigstens eine der nachfolgenden Informationen umfasst:
- Eine Lokalisierungsinformation,
- Eine Leitungsinformation.

6. Verfahren (100) nach einem der vorhergehenden Ansprüche,
**dadurch gekennzeichnet,**
**dass** das Alarmprotokoll zusätzlich wenigstens eines der nachfolgenden umfasst:
- Erstellen wenigstens eines Fehlerdatensatzes umfassend wenigstens einen Spannungswert (U) sowie wenigstens Zeitstempel, wobei jedem Spannungswert (U) in dem Erfassungsdatensatz ein Zeitstempel zugeordnet ist,
- Übertragen wenigstens eines Fehlerdatensatzes an einen zentralen Server (18) und/oder an wenigstens ein mobiles Gerät (17),
- Empfangen wenigstens einer Betriebsanweisung, insbesondere von einem zentralen Server (18) und/oder einem mobilen Gerät (17),
- Durchführen einer Fehlerortung an der Energieleitung (5), insbesondere durch Impulsreflexion.

7. Verfahren (100) nach Anspruch 6,
**dadurch gekennzeichnet,**
**dass** wenigstens ein Fehlerdatensatz wenigstens eine der nachfolgenden Informationen umfasst:
- Eine Lokalisierungsinformation,
- Eine Leitungsinformation.

8. Verfahren (100) nach einem der Ansprüche 6 bis 7,
**dadurch gekennzeichnet,**
**dass** der Fehlerdatensatz wenigstens zwei, vorzugsweise wenigstens drei, Spannungswerte (U) in einem, insbesondere zusammenhängenden, Erfassungszeitraum umfasst, insbesondere dass ein Anfangszeitpunkt des Zeitintervalls durch ein Überschreiten des Spannungsgrenzwerts (G) durch wenigstens einen Spannungswert (U) festgelegt ist.

9. Verfahren (100) nach Anspruch 8,
**dadurch gekennzeichnet,**
**dass** ein Endzeitpunkt des Erfassungszeitraums durch wenigstens eines der folgenden Ereignisse festgelegt ist:
- Unterschreiten des Spannungsgrenzwerts (G) durch wenigstens einen Spannungswert (U),
- Ablauf einer Zeitspanne ab dem Anfangszeitpunkt des Erfassungszeitraums, wobei die Zeitspanne wenigstens ein Viertel, vorzugsweise wenigstens die Hälfte, der Periodendauer (T) der an der Energieleitung (5) anliegenden Wechselspannung beträgt.

10. Vorrichtung (10), die insbesondere nach einem Verfahren (100) gemäß einem der Ansprüche 1 bis 9 betreibbar ist, zur Überwachung wenigstens einer Energieleitung (5) in einem Mittelspannungsnetz (3), umfassend:
- Wenigstens eine Erfassungseinheit (11) zur Erfassung von Spannungswerten (U) durch eine zeitdiskrete Erfassung der elektrischen Spannung auf einem Kabelschirm (5.5) der Energieleitung (5),
- Wenigstens eine Auswerteeinheit (12) zur Auswertung wenigstens eines Spannungswerts (U),
- Wenigstens eine Steuereinheit (13) zur Aktivierung eines Alarmprotokolls, sofern der Spannungsgrenzwert (G) durch wenigstens einen der erfassten Spannungswerte (U) überschritten wurde.

11. Vorrichtung (10) nach Anspruch 10,
**dadurch gekennzeichnet,**
**dass** die Vorrichtung (10) zusätzlich wenigstens eines der folgenden umfasst:
- Wenigstens eine Kommunikationseinheit (14), insbesondere zur Übertragung wenigstens eines Fehlerdatensatzes an wenigstens einen zentralen Server (18) und/oder wenigstens ein mobiles Gerät (17),
- Wenigstens eine Speichereinheit (15) zur zumindest temporären Speicherung wenigstens eines Erfassungsdatensatzes und/oder wenigstens eines Fehlerdatensatzes und/oder wenigstens einer Aktivierungsinformation,
- Wenigstens eine Lokalisierungseinheit (16) zur Erfassung wenigstens einer Standortinformation.

12. Umspannwerk (20) umfassend wenigstens einen Transformator (21) zur Umwandlung von Hochspannung in Mittelspannung oder Mittelspannung in Niederspannung sowie wenigstens eine Vorrichtung (10) nach einem der Ansprüche 10 bis 11, wobei die Vorrichtung (10) derart in dem Umspannwerk (20) angeordnet ist, dass wenigstens eine zumindest abschnittsweise in dem Umspannwerk (20) angeordnete Energieleitung (5) eines Mittelspannungsnetzes (3) durch die Vorrichtung (10) überwachbar ist.

13. System (30) zur Überwachung wenigstens einer Energieleitung (5) in einem Mittelspannungsnetz (3), umfassend wenigstens eine Vorrichtung (10) nach einem der Ansprüche 10 bis 11 sowie wenigstens einen zentralen Server (18) und/oder wenigstens ein mobiles Gerät (17).

14. Computerprogrammprodukt, umfassend Befehle, die bewirken, dass eine Vorrichtung (10) gemäß einem der Ansprüche 10 bis 11 ein Verfahren (100) gemäß einem der Ansprüche 1 bis 10 ausführt.

15. Computerlesbares Speichermedium, auf dem ein Computerprogrammprodukt nach Anspruch 14 gespeichert ist.
